# EUROPÄISCHE PATENTSCHRIFT

(11) **EP 0 378 777 B1**
(45) Veröffentlichungstag und Bekanntmachung des Hinweises auf die Patenterteilung: **17.04.1996**
(21) Anmeldenummer: 89121102.1
(22) Anmeldetag: 15.11.1989
(51) Int. Cl.: H03M 1/46, G06F 3/05, H03M 3/02

(54) **Anordnung zur Umsetzung analoger Signale in digitale**
Arrangement for converting analog signals into digital signals
Agencement de conversion de signaux analogiques en signaux numériques

(30) Priorität: 19.01.1989 DE 3901399
(43) Veröffentlichungstag der Anmeldung: 25.07.1990
(73) Patentinhaber: Daimler-Benz Aerospace Aktiengesellschaft, D-81663 München (DE)
(72) Erfinder: Bühler, Wolfhardt, D-8000 München 82 (DE); Poisel, Hans, Dr., D-8060 Dachau (DE); Trommer, Gert, Dr., D-8000 München 40 (DE)

(56) Entgegenhaltungen:
- EP-A- 0 072 144
- EP-A- 0 169 535
- DE-A- 2 414 347
- DE-A- 2 952 311
- FR-A- 2 564 665
- US-A- 4 558 301
- D. SEITZER et al.: Electronic Analog-to-Digital Converters, 1983, John Wiley & Sons, Seiten 58,59

## Beschreibung

Moderne Datenaquisationssysteme verwenden Analog/Digital-Wandler im wesentlichen dreier Kategorien:
Wandler mit sehr kurzen Umwandlungszeiten, sog. Half Flash-Wandler,
Wandler nach dem Verfahren der sukzessiven Approximation (SAR), bei denen die Eingangsspannung mit der Ausgangsspannung eines Digital/Analog-Wandlers verglichen wird, der vom SAR-Register angesteuert wird und
integrierende Wandler, die überall dort eingesetzt werden wo es nicht auf kurze Wandlungszeiten ankommt.

Will man den Fehler klein halten, so muß beim sogenannten Half Flash-Wandler der Innenwiderstand klein sein.

Die SAR-Wandler sind hinsichtlich ihrer Eingangsspannung sehr empfindlich. Am unempfindlichsten aller drei angeführten Wandlerarten ist, jedenfalls bezüglich Innenwiderstand, ein integrierter Wandler. Man muß sich jedoch bei diesem Wandler der Tatsache bewußt sein, daß der Eingangsstrom im wesentlichen ein Leckstrom ist und daß sich bei mehreren Integrationsstufen die Fehler summieren.

Aus der US-A-4 558 301 ist ein Verfahren bekannt, das sich auf einen A/D-Wandler bezieht, dessen Frequenz mittels Prozessor in ein Digitalsignal gewandelt wird. Grundlage ist ein Komparator, der das Ausgangssignal eines Integrators etwa auf Null regelt. Das Ausgangssignal ist frequenzabhängig von der Meßgröße. Mit den bekannten Maßnahmen ist eine Frequenzunabhängigkeit des Ausgangssignals und ein Regelungsverzicht auf Null des Integrators nicht möglich.

Aus der Druckschrift D. Seitzer et. al.: Electronic Analog-to Digital Converters, 1983, John Wiley & sons, Seiten 58 u. 59 ist es bekannt, nach "n" A/D-Wandlungszyklen einen Mittelwert zu bilden. Abgesehen davon, daß das Meßergebnis erst nach "n" Zyklen vorliegt, werden bei hochdynamischen Vorgängen Meßfehler erzeugt.

Aufgabe der Erfindung ist es, eine Anordnung zur Analog/Digital-Umsetzung insbesondere der vorstehend genannten dritten Art zu schaffen, die trotz niedrigem Schaltungsaufwand und größerer Geschwindigkeit der Umsetzung Quantisierungsfehler vermeidet.

Gelöst wird diese Aufgabe mit den Merkmalen des Patentanspruchs 1, wobei ein Analog-Integrator die Differenz zwischen dem Meßsignal und dem Signal eines von einem Mikroprozessor bzw. Mikrocomputer gesteuerten Digital/Analog-Wandlers integriert. Weitere Merkmale der Erfindung sind Ansprüchen, Beschreibung und Zeichnung eines Ausführungsbeispiels zu entnehmen.

Die wesentlichen Vorteile der Erfindung sind
a) kein Quantisierungsfehler mehr
b) höhere Auflösung
c) geringeres Rauschen
d) größere Geschwindigkeit
e) geringer Aufwand

Mit der Erfindung ist es möglich eine sich rasch ändernde Analogspannung, welche mit Rauschen und mit Störsignalen behaftet ist, in einem festen Zeitraster abzutasten und zu digitalisieren, wobei der Augenblickswert der angelegten Spannung mit möglichst großer Genauigkeit erfaßt wird. Ferner kann bei der Erfindung aus den Digitalwerten über lange Zeiten mit minimalem Fehler integriert werden. Die Abtastrate zwischen zwei Abtastzeitpunkten spielt dabei für die Integration keine Rolle mehr, ebensowenig die beschränkte Bit-Zahl des A/D-Wandlers, welche zu Digitalisierungsfehlern im Stand der Technik führen kann. Beide Fehlerarten können zu einem sich zeitlich vergrößernden Fehler des integrierten Signals führen.
Die Erfindung vermeidet diese Fehler mit einem verblüffend geringen Aufwand.

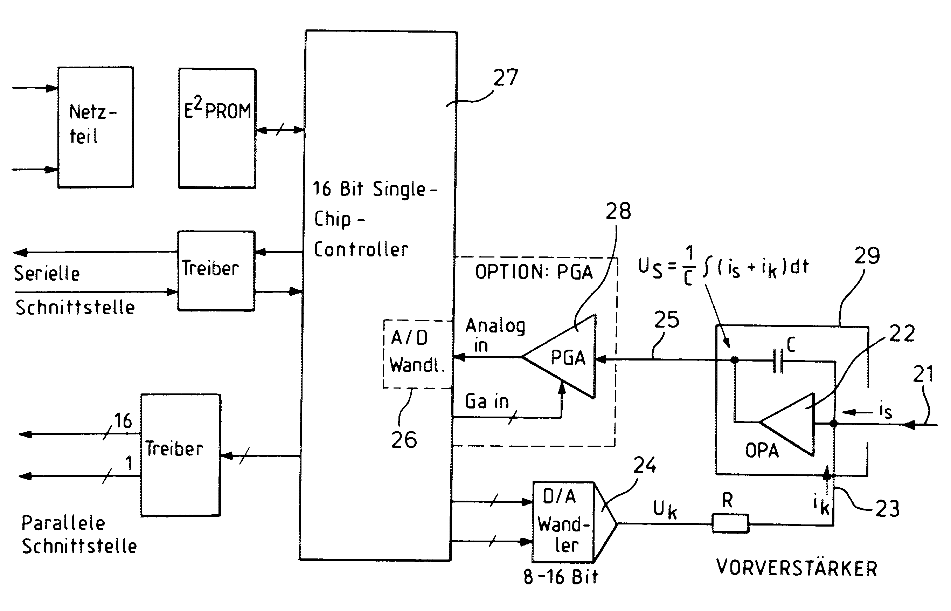

Ein Ausführungsbeispiel der Erfindung ist in der beigefügten Zeichnung rein schematisch dargestellt. Wie die einzige Figur zeigt, wird das analoge Meßsignal 21 bei dieser Umsetzung im Bereich der Eingangsschaltung für einen Mikroprozessor oder Mikrocomputer bereits im analogen Vorverstärker 22 zusammen mit einem Signal 23 eines D/A-Wandlers 24 integriert. Das analoge Integrationssignal 25 wird nun von einem A/D-Wandler 26, an den keine besonderen Anforderungen gestellt werden müssen - insbesondere nicht hinsichtlich der Bit-Zahl - digitalisiert und dem Mikroprozessor oder Mikrocomputer 27 zugeführt. In diesen ist mit Vorteil der A/D-Wandler 26 integriert.

Für besondere Anforderungen im dynamischen Arbeitsbereich (je nach Wahl von R und C das Produkt aus der Auflösung des A/D-Wandlers und der Auflösung des D/A-Wandlers) ist ein Verstärkungsgradanpassungsglied PGA 28 (PGA = programmable-Gain-Amplifier) in der Eingangsschaltung des A/D-Wandlers und des Datenaquisitionssystems mit Mikroprozessor bzw. Mikrocomputer vorgesehen. Das PGA 28 ist dem Integrator 29 nachgeschaltet und dem Eingang des A/D-Wandlers 26 direkt zugeschaltet.

Aufgabe des Mikroprozessors oder Mikrocomputers ist es zunächst, in einer Regelschleife der Eingangsschaltung mit Hilfe des D/A-Wandlers dafür zu sorgen, daß der Integrator 29, der hier weder gelöscht noch zurückgesetzt werden kann, nicht in Sättigung geht. Der in einem bestimmten Meßintervall zu ermittelnde Meßwert entspricht dann der Summe aus dem Wert des D/A-Wandlers und der Änderung des Integrationssignals unter Berücksichtigung der durch die Beschaltung gegebenen Skalenfaktoren und Offsets (Abweichungen).

Dabei wird die Auflösung der Ansprechschwelle nicht mehr vom A/D-Wandler begrenzt, sondern aufgrund der Verwendung des PGA's 28, nur durch das Signal/Rauschverhältnis des Meßsignals bei vorgegebenen Meßintervall. Optimale Rausch- und Störunterdrückung wird durch die Verwendung des Prozessor-gesteuerten integrierenden Wandlers gewährleistet. Die angegebene Lösung ist besonders bei größeren Stückzahlen äußerst günstig, weil die D/A-Wandler erheblich billiger als A/D-Wandler gleicher Auflösung sind.
In einer Abwandlung des Ausführungsbeispieles kann der D/A-Wandler dadurch realisiert werden, daß der Mikroprozessor oder Mikrocomputer Pulslängen-modulierte Ausgänge aufweist, welche mit dem Integrator 29 verbunden sind.

Eine vorteilhafte Anwendung der Erfindung ist bei Inertialsystemen insbesondere Faserkreiseln. In der Regel haben diese drei Ausgänge für die drei Raumachsen und es ist besonders vorteilhaft mit mehreren Eingangsschaltungen - hier drei - parallel zu arbeiten. Will man das digitale Ausgangssignal integrieren, hier z.B. einer Drehrate, deren zeitliche Integration erst einen Lagewinkel liefert - so wird das Ergebnis nicht durch Abtastfehler bzw. schlechte Auflösung des A/D-Wandler beeinträchtigt.

## Patentansprüche

1. Anordnung zur Umsetzung analoger Signale in digitale mit einem ein- oder mehrstufigen Verstärker, der die Eingangsschaltung eines Analog/Digitalwandlers bildet, dessen digitale Ausgangsdaten einem Mikroprozessor oder Mikrocomputer zugeführt werden, wobei wenigstens ein Verstärker der Eingangsschaltung als Integrator (29) mit im Rückkopplungszweig enthaltener Kapazität ausgebildet ist, an dessen Eingang die Differenz des analogen Meßsignals und eines vom Mikroprozessor oder Mikrocomputer mittels D/A-Wandlung (24) gesteuerten Signals anliegt, wobei der Integrator (29) durch die Signalrückkopplung ohne Reset so geregelt wird, daß er nie in Sättigung gerät, sowie der in einem Meßintervall in festem Zeitraster/fester Taktfolge ermittelte Digitalwert aus der Summe des Wertes des D/A-Wandlers (24) und der durch den A/D-Wandler (26) erfaßten Änderung des Integratorsignals gebildet wird und ein vom Mikroprozessor oder Mikrocomputer (27) gesteuertes programmierbares Verstärkungsgradanpassungsglied (PGA) (28) dem Integrator (29) nachgeschaltet und dem Eingang des A/D-Wandlers (26) direkt zugeschaltet ist.

2. Anordnung nach Anspruch 1, **dadurch gekennzeichnet**, daß der Mikroprozessor oder Mikrocomputer (27) Ausgänge aufweist, die mit dem D/A-Wandler (24) verbunden sind, dessen analoges Ausgangssignal dem Integrator (29) zugeführt wird.

3. Anordnung nach Anspruch 1 oder 2, **dadurch gekennzeichnet**, daß der D/A-Wandler (24) dadurch realisiert wird, daß der Mikroprozessor oder Mikrocomputer (27) Ausgänge aufweist, die pulslängenmodulierte Signale abgeben, welche dem Integrator (29) zugeführt werden.

4. Anordnung nach einem der Ansprüche 1 bis 3, **dadurch gekennzeichnet**, daß der A/D-Wandler (26) mit dem Mikroprozessor oder Mikrokomputer eine Baueinheit bildet.

5. Anordnung nach einem der Ansprüche 1 bis 4, **dadurch gekennzeichnet**, daß der Mikroprozessor oder Mikrocomputer (27) mit mehreren parallel arbeitenden Eingangsschaltungen verbunden ist.

## Claims

1. Arrangement for converting analog signals into digital signals with a single-stage or multistage amplifier which forms the input circuit of an analog-digital converter whose digital output data are fed to a microprocessor or microcomputer, at least one amplifier of the input circuit being constructed as an integrator (29) with capacitance contained in the feedback branch, at the input of which integrator the difference between the analog measurement signal and a signal which is controlled by the microprocessor or microcomputer by means of digital-analog conversion (24) is present, the integrator (29) being controlled by the signal feedback without reset in such a way that it never becomes saturated and the digital value identified in one measurement interval in the fixed time frame/fixed clock sequence is formed from the sum of the value of the digital-analog converter (24) and the change, detected by the analog-digital converter (26), in the integrator signal, and a programmable gain adapting element (PGA) (28) controlled by the microprocessor or microcomputer (27), is connected downstream of the integrator (29) and is directly connected to the input of the analog-digital converter (26).

2. Arrangement according to Claim 1, characterized in that the microprocessor or microcomputer (27) has outputs which are connected to the digital-analog converter (24) whose analog output signal is fed to the integrator (29).

3. Arrangement according to Claim 1 or 2, characterized in that the digital-analog converter (24) is realised in such a manner that the microprocessor or microcomputer (27) has outputs which output pulse-length-modulated signals which are fed to the integrator (29).

4. Arrangement according to one of Claims 1 to 3, characterized in that the analog-digital converter (26) forms a physical unit with the microprocessor or microcomputer.

5. Arrangement according to one of Claims 1 to 4, characterized in that the microprocessor or microcomputer (27) is connected to a plurality of input circuits which operate in parallel.

## Revendications

1. Agencement pour la conversion de signaux analogiques en signaux numériques avec un amplificateur mono- ou multi-étages qui constitue le circuit d'entrée d'un convertisseur analogique/numérique, dont les données numériques de sortie sont envoyées à un microprocesseur ou à un micro-ordinateur, au moins un amplificateur du circuit d'entrée étant agencé sous forme d'intégrateur (29) avec une capacité placée dans la branche de réinjection, à l'entrée duquel est appliquée la différence entre le signal de mesure analogique et un signal d'un convertisseur N/A (24) commandé par le microprocesseur ou le micro-ordinateur, l'intégrateur (29) étant réglé sans réinitialisation par la réinjection du signal de telle sorte qu'il n'arrive jamais à saturation et la valeur numérique déterminée dans un intervalle de mesure, dans une tranche de temps fixe/une séquence fixe, étant formée de la somme de la valeur délivrée par le convertisseur N/A (26) et de la variation du signal d'intégrateur mesurée par le convertisseur A/N (26) et un circuit (PGA) (28) programmable d'adaptation du taux d'amplification, commandé par le microprocesseur ou le micro-ordinateur (27), étant placé à la suite de l'intégrateur (29) et connecté directement à l'entrée du convertisseur A/N (26).

2. Agencement selon la revendication 1, caractérisé par le fait que le microprocesseur ou le micro-ordinateur (27) comporte des sorties qui sont connectées au convertisseur N/A (24) et dont le signal analogique de sortie est appliqué à l'intégrateur (29).

3. Agencement selon la revendication 1 ou 2, caractérisé par le fait que le convertisseur N/A (24) est agencé de telle sorte que le microprocesseur ou le micro-ordinateur (27) comporte des sorties qui délivrent des signaux modulés en longueur d'impulsion qui sont appliqués à l'intégrateur (29).

4. Agencement selon l'une des revendications 1 à 3, caractérisé par le fait que le convertisseur A/N (26) forme avec le microprocesseur ou le micro-ordinateur une unité de construction.

5. Agencement selon l'une des revendications 1 à 4, caractérisé par le fait que le microprocesseur ou le micro-ordinateur (27) est connecté à plusieurs circuits d'entrée qui travaillent en parallèle.
